# EUROPÄISCHE PATENTSCHRIFT

(11) **EP 3 485 565 B1**
(45) Veröffentlichungstag und Bekanntmachung des Hinweises auf die Patenterteilung: **27.05.2020**
(21) Anmeldenummer: 16765942.4
(22) Anmeldetag: 05.09.2016
(51) Int. Cl.: H02M 7/483, H03K 17/0814, H03K 17/723

(54) **VERFAHREN ZUM ENTLADEN EINES ELEKTRISCHEN ENERGIESPEICHERS**
METHOD FOR DISCHARGING AN ELECTRIC ENERGY STORAGE UNIT
PROCÉDÉ DE DÉCHARGE D'UN ACCUMULATEUR D'ÉNERGIE ÉLECTRIQUE

(43) Veröffentlichungstag der Anmeldung: 22.05.2019
(73) Patentinhaber: Siemens Aktiengesellschaft, 80333 München (DE)
(72) Erfinder: DORN, Jörg, 96155 Buttenheim (DE); SCHMITT, Daniel, 92353 Postbauer-Heng (DE); SCHREMMER, Frank, 90768 Fürth (DE); WAHLE, Marcus, 90587 Veitsbronn (DE)
(86) Internationale Anmeldenummer: PCT/EP2016/070832
(87) Internationale Veröffentlichungsnummer: WO 2018/041370

(56) Entgegenhaltungen:
- EP-A1- 1 427 107
- WO-A1-2013/044961
- DE-A1-102005 040 543
- DE-A1-102014 200 108

## Beschreibung

Die Erfindung betrifft ein Verfahren zum Entladen eines elektrischen Energiespeichers. In elektrischen Energiespeichern (beispielsweise in elektrischen Kondensatoren) können große Energiemengen gespeichert sein. Diese großen Energiemengen können im Fehlerfall schwer zu beherrschen sein, da die Energie im Fehlerfall unkontrolliert und schlagartig freigesetzt werden kann und sich daraufhin in andere Energieformen umwandeln kann. Eine an den elektrischen Energiespeicher angeschlossene elektronische Schaltung oder Komponente (z.B. ein Leistungshalbleiter) ist dann oft nicht in der Lage, diese freiwerdenden Energiemengen aufzunehmen und zu kontrollieren. Dies kann dazu führen, dass die elektronische Schaltung im Fehlerfall komplett zerstört wird, zum Beispiel durch eine Explosion. Bei der Zerstörung der elektronischen Schaltung kann es außerdem zu Folgeschäden an benachbarten Betriebsmitteln kommen. Ursachen für solche Folgeschäden können beispielsweise elektrische Lichtbögen, große magnetische Stromkräfte oder auch starke Verunreinigungen aufgrund der genannten Explosion sein.

Aus der internationalen Patentanmeldung WO 2013/044961 A1 ist eine Kurzschlussstromentlastung für ein Submodul eines modularen Mehrstufenstromrichters bekannt. Dabei ist ein Thyristor parallel zu einem elektrischen Kondensator geschaltet, um im Fehlerfall den Entladestrom des Kondensators kontrolliert durch den Thyristor abzuleiten und die an dem Kondensator angeschlossene elektronische Schaltung zu schützen. Diese bekannte Kurzschlussstromentlastung weist eine elektronische Auswerteschaltung auf, welche das Vorliegen eines Fehlers erkennt und bei Vorliegen eines Fehlers einen Gatestrom in den Gate-Anschluss des Thyristors einleitet, so dass der Thyristor einschaltet /zündet. Zur Realisierung dieser Auswerteschaltung sind zusätzliche elektronische Bauelemente notwendig und die Auswerteschaltung benötigt eine gewisse Zeitdauer, um den Fehler zu erkennen und den Gatestrom für den Thyristor bereitzustellen. Außerdem reduziert die Auswerteschaltung die Zuverlässigkeit des Schutzelements, d.h. der Kurzschlussstromentlastung.

Der Erfindung liegt die Aufgabe zugrunde, ein Verfahren zum Entladen eines elektrischen Energiespeichers und eine Anordnung anzugeben, bei denen keine zusätzliche Auswerteschaltung notwendig ist.

Diese Aufgabe wird erfindungsgemäß gelöst durch ein Verfahren und eine Anordnung nach den unabhängigen Patentansprüchen. Vorteilhafte Ausführungsformen des Verfahrens und der Anordnung sind in den abhängigen Patentansprüchen angegeben.

Offenbart wird ein Verfahren zum Entladen eines elektrischen Energiespeichers, der mittels eines ersten elektrischen Leiters und eines zweiten elektrischen Leiters mit einer elektronischen Schaltung verbunden ist, wobei ein Thyristor zum Entladen des Energiespeichers (im Fehlerfall) vorgesehen ist, wobei bei dem Verfahren
- aufgrund eines in der elektronischen Schaltung aufgetretenen Fehlers (insbesondere aufgrund eines in der elektronischen Schaltung aufgetretenen Kurzschlusses) ein Entladestrom des Energiespeichers von dem Energiespeicher über den ersten elektrischen Leiter zu der elektronischen Schaltung und über zweiten elektrischen Leiter zurück zu dem Energiespeicher zu fließen beginnt,
- aufgrund des (ansteigenden) Entladestroms um den ersten elektrischen Leiter und den zweiten elektrischen Leiter herum ein sich zeitlich änderndes Magnetfeld erzeugt wird, welches das Halbleitermaterial des Thyristors durchdringt,
- durch das sich zeitlich ändernde Magnetfeld in dem Halbleitermaterial des Thyristors ein Strom (Wirbelstrom) induziert (eingeprägt) wird, und
- (ausschließlich) durch diesen induzierten Strom der Thyristor eingeschaltet wird (wodurch der Entladestrom des Energiespeichers durch den eingeschalteten Thyristor fließt und dadurch an der elektronischen Schaltung vorbeigeleitet wird). Der eingeschaltete Thyristor übernimmt also den Entladestrom des Energiespeichers (mindestens einen wesentlichen Teil des Entladestroms des Energiespeichers), d.h. der eingeschaltete Thyristor leitet den Entladestrom des Energiespeichers ab. Der Energiespeicher kann zum Beispiel ein kondensatorartiger Energiespeicher sein, beispielsweise ein elektrischer Kondensator, eine elektrische Batterie oder ein elektrischer Akkumulator. Der induzierte Strom kann in dem Thyristor als ein Gatestrom oder als ein Zündstrom wirken. Der Gatestrom ist ein Strom, der durch die Gate-Halbleiterstruktur des Thyristors fließt und den Thyristor einschaltet; der Zündstrom ist ein Strom, der im Thyristor außerhalb der Gate-Halbleiterstruktur des Thyristors fließt und den Thyristor einschaltet.

Mit anderen Worten gesagt, wird der Thyristor durch den induzierten Strom (Wirbelstrom) eingeschaltet. Dadurch fließt der Entladestrom des Energiespeichers unter Umgehung der elektronischen Schaltung durch den eingeschalteten Thyristor. Der Thyristor kann dabei räumlich benachbart zu dem ersten elektrischen Leiter und/oder dem zweiten elektrischen Leiter angeordnet sein.

Bei diesem Verfahren ist besonders vorteilhaft, dass das sich zeitlich ändernde Magnetfeld (welches aufgrund des ansteigenden Entladestroms des Energiespeichers entsteht) unmittelbar dazu genutzt wird, um den Thyristor einzuschalten (das heißt, den Thyristor zu zünden). Dazu sind keine weiteren Bauelemente und auch keine weitere Auswerteschaltung notwendig. Dadurch lässt sich dieses Verfahren sehr einfach, kostengünstig und zuverlässig realisieren. Außerdem werden Zeitverzögerungen beim Einschalten des Thyristors vermieden. (Eine Auswerteschaltung, die aus zusätzlichen elektronischen Bauelementen besteht, würde naturgemäß solche Verzögerungen mit sich bringen.) Es handelt sich also um einen selbstzündenden Thyristor ohne eine zusätzliche Schaltverzugszeit aufgrund zusätzlicher Detektions- bzw.

Zündelektroniken in einer zusätzlichen Auswerteschaltung (die Zündverzugszeit des Thyristors bleibt dabei unverändert: die Zündverzugszeit des Thyristors liegt in der Regel im Bereich von wenigen µs, typisch sind 1-3 µs). Aufgrund der Abwesenheit von zusätzlichen Bauelementen und einer zusätzlichen Auswerteschaltung treten auch keine zusätzlichen elektrischen Verluste auf. Insbesondere bei einer leistungselektronischen Anlage, in der sehr viele elektrische Energiespeicher vorhanden sind (wie beispielsweise bei einem modularen Multilevelstromrichter), können dadurch die elektrischen Verluste nennenswert verringert werden. Dadurch kann die Energieeffizienz der Anlage verbessert werden. Bei dem beschriebenen Verfahren werden nur geringe elektrische Verluste durch den Leckstrom des Thyristors verursacht; dieser Leckstrom ist in der Regel sehr gering.

Das beschriebene Verfahren ermöglicht also aufgrund der Vermeidung von zusätzlichen elektronischen Bauelemente beziehungsweise der Vermeidung einer zusätzlichen elektronischen Auswerteschaltung eine große Kosteneinsparung sowie eine Reduzierung der Ausfallrate (FIT-Rate, FIT = failure in time). Da die nicht vorhandenen Bauelemente nicht kaputtgehen können, wird die Wahrscheinlichkeit des Auftretens eines Fehlers deutlich reduziert.

Das Verfahren kann so ablaufen, dass durch den induzierten Strom der Thyristor eingeschaltet wird, wenn die zeitliche Änderung des Magnetfelds einen Schwellwert überschreitet. Dieser Schwellwert kann wesentlich beeinflusst werden durch Wahl der räumlichen Anordnung des Thyristors zu dem ersten elektrischen Leiter und/oder dem zweiten elektrischen Leiter. Je größer beispielsweise der Abstand zwischen Thyristor und dem ersten elektrischen Leiter oder dem zweiten elektrischen Leiter ist, desto größer muss die zeitliche Änderung des Entladestroms sein, um eine zum Einschalten des Thyristors ausreichend starke zeitliche Änderung des Magnetfeldes zu erzeugen. Mit anderen Worten gesagt, kann das Verfahren so ablaufen, dass durch den induzierten Strom der Thyristor eingeschaltet wird, wenn die zeitliche Änderung des Entladestroms einen Schwellwert überschreitet.

Das Verfahren kann so ausgestaltet sein, dass die elektronische Schaltung mindestens zwei (ein- und abschaltbare) elektronische Schaltelemente aufweist, die in einer Halbbrückenschaltung angeordnet sind (wobei die Halbbrückenschaltung parallel zu dem Energiespeicher geschaltet ist). Eine derartige elektronische Schaltung ist beispielsweise in sogenannten Halbbrücken-Submodulen eines modularen Multilevelstromrichters enthalten.

Das Verfahren kann auch so ausgestaltet sein, dass die elektronische Schaltung die zwei elektronischen Schaltelemente und zwei weitere (ein- und abschaltbare) elektronische Schaltelemente aufweist, wobei die zwei elektronischen Schaltelemente und die zwei weiteren elektronischen Schaltelemente in einer Vollbrückenschaltung angeordnet sind. Eine solche elektronische Schaltung ist beispielsweise in sogenannten Vollbrücken-Submodulen eines modularen Multilevelstromrichters enthalten.

Offenbart wird weiterhin eine Anordnung mit einer elektronischen Schaltung und einem elektrischen Energiespeicher, der mittels eines ersten elektrischen Leiters und eines zweiten elektrischen Leiters mit der elektronischen Schaltung verbunden ist, und mit einem Thyristor zum Entladen des Energiespeichers (im Fehlerfall), wobei der Thyristor derart räumlich benachbart zu dem ersten elektrischen Leiter und/oder dem zweiten elektrischen Leiter angeordnet ist, dass aufgrund eines sich zeitlich ändernden Magnetfelds, welches aufgrund eines durch mindestens einen der elektrischen Leiter (zum Beispiel aufgrund eines durch den ersten elektrischen Leiter und/oder den zweiten elektrischen Leiter) fließenden Entladestroms des Energiespeichers entsteht und welches das Halbleitermaterial des Thyristors durchdringt, in dem Halbleitermaterial des Thyristors ein Strom (Wirbelstrom) induziert (eingeprägt) wird, der den Thyristor einschaltet (wenn die zeitliche Änderung des Magnetfelds einen Schwellwert überschreitet). Dabei kann der Energiespeicher zum Beispiel ein kondensatorartiger Energiespeicher sein, beispielsweise ein elektrischer Kondensator, eine elektrische Batterie oder ein elektrischer Akkumulator. Der induzierte Strom kann in dem Thyristor als ein Gatestrom oder als ein Zündstrom wirken. Diese Anordnung weist dieselben Vorteile auf, die oben im Zusammenhang mit dem Verfahren angegeben sind.

Die Anordnung kann auch so ausgestaltet sein, dass der Thyristor in einem Zwischenraum zwischen dem ersten elektrischen Leiter und dem zweiten elektrischen Leiter angeordnet ist. Bei dieser Anordnung wird der Thyristor besonders gut sowohl von dem Magnetfeld des ersten elektrischen Leiters als auch von dem Magnetfeld des zweiten elektrischen Leiters durchdrungen.

Die Anordnung kann auch so ausgestaltet sein, dass die Anode des Thyristors (elektrisch leitend) mit dem ersten elektrischen Leiter verbunden ist und die Kathode des Thyristors (elektrisch leitend) mit dem zweiten elektrischen Leiter verbunden ist. Mit anderen Worten kann der Thyristor unmittelbar zwischen dem ersten elektrischen Leiter und dem zweiten elektrischen Leiter geschaltet sein. Dabei sind vorteilhafterweise nur zwei Kontaktstellen (eine Kontaktstelle zwischen der Anode und dem ersten elektrischen Leiter, eine zweite Kontaktstelle zwischen der Kathode und dem zweiten elektrischen Leiter) notwendig.

Die Anordnung kann auch so ausgestaltet sein, dass der Thyristor zwischen dem ersten elektrischen Leiter und dem zweiten elektrischen Leiter mechanisch verspannt ist. (Der erste elektrische Leiter, der Thyristor und der zweite elektrische Leiter bilden einen Spannverband.) Durch die mechanische Verspannung wird vorteilhafterweise ein guter elektrischer Kontakt zwischen dem ersten elektrischen Leiter und dem Thyristor (genauer gesagt zwischen dem ersten elektrischen Leiter und der Anode des Thyristors) und dem zweiten elektrischen Leiter und dem Thyristor (genauer gesagt zwischen dem zweiten elektrischen Leiter und der Kathode des Thyristors) sichergestellt.

Die Anordnung kann auch so ausgestaltet sein, dass der Thyristor ein Scheibenzellengehäuse aufweist. Ein derartiger Thyristor mit Scheibenzellengehäuse lässt sich vorteilhafterweise besonders einfach zwischen dem ersten elektrischen Leiter und dem zweiten elektrischen Leiter mechanisch verspannen.

Die Anordnung kann auch so ausgestaltet sein, dass der erste elektrische Leiter und/oder der zweite elektrische Leiter jeweils als eine Stromschiene ausgestaltet sind. Mittels einer derartigen Stromschiene lässt sich zum einen auch ein großer Entladestrom des Energiespeichers sicher leiten; zum anderen kann mittels einer (mechanisch stabilen) Stromschiene der Thyristor zuverlässig mechanisch verspannt werden.

Die Anordnung kann auch so ausgestaltet sein, dass der erste elektrische Leiter und/oder der zweite elektrische Leiter jeweils eine ebene Außenfläche aufweisen, das Halbleitermaterial des Thyristors eine Scheibe (Wafer) bildet und die Scheibe parallel zu mindestens einer der ebenen Außenflächen angeordnet ist. (Dabei kann insbesondere der erste elektrische Leiter eine erste ebene Außenfläche aufweisen, der zweite elektrische Leiter eine zweite ebene Außenfläche aufweisen, die erste ebene Außenfläche parallel zu der zweiten ebenen Außenfläche angeordnet sein, das Halbleitermaterial des Thyristors eine Scheibe (Wafer) bilden und die Scheibe parallel zu der ersten ebenen Außenfläche und zu der zweiten ebenen Außenfläche angeordnet sein.) Eine derartige Anordnung ermöglicht vorteilhafterweise einen geringen Abstand zwischen dem ersten elektrischen Leiter und dem zweiten elektrischen Leiter. Dadurch kann zwischen dem ersten elektrischen Leiter und dem zweiten elektrischen Leiter ein besonders starkes Magnetfeld erzeugt werden. Außerdem hat sich gezeigt, dass bei einer derartigen Anordnung das sich zeitlich ändernde Magnetfeld das Halbleitermaterial des Thyristors besonders gut durchdringt, so dass in dem Halbleitermaterial des Thyristors zuverlässig der Strom (der zum Beispiel als Gatestrom wirkt) induziert wird.

Die Anordnung kann auch so ausgestaltet sein, dass der Thyristor niederinduktiv mit dem Energiespeicher verbunden ist. (Dabei weist die elektrische Verbindung zwischen dem Energiespeicher und dem Thyristor eine kleinere elektrische Induktivität auf als die elektrische Verbindung zwischen dem Energiespeicher und der elektronischen Schaltung.) Dabei ist besonders vorteilhaft, dass nach dem Einschalten des Thyristors der Entladestrom des Energiespeichers durch den Thyristor fließt und nicht (oder nur in sehr geringem Umfang) durch die elektronische Schaltung.

Die Anordnung kann auch so ausgestaltet sein, dass der Thyristor parallel zu dem Energiespeicher geschaltet ist. Dies ermöglicht es, den Thyristor besonders dicht an dem Energiespeicher anzuordnen, wodurch eine besonders niederinduktive elektrische Verbindung zwischen dem Energiespeicher und dem Thyristor möglich ist.

Die Anordnung kann auch so ausgestaltet sein, dass die elektronische Schaltung mindestens zwei (ein- und abschaltbare) elektronische Schaltelemente aufweist, die in einer Halbbrückenschaltung angeordnet sind (wobei die Halbbrückenschaltung parallel zu dem Energiespeicher geschaltet ist). Eine derartige elektronische Schaltung ist beispielsweise in sogenannten Halbbrücken-Submodulen von einem modularen Multilevelstromrichter enthalten.

Die Anordnung kann auch so ausgestaltet sein, dass die elektronische Schaltung die zwei elektronischen Schaltelemente und zwei weitere (ein- und abschaltbare) elektronische Schaltelemente aufweist, wobei die zwei elektronischen Schaltelemente und die zwei weiteren elektronischen Schaltelemente in einer Vollbrückenschaltung angeordnet sind. Eine derartige elektronische Schaltung ist beispielsweise in sogenannten Vollbrücken-Submodulen von modularen Mehrstufenstromrichtern enthalten.

Offenbart wird weiterhin ein Modul eines modularen Multilevelstromrichters, das eine Anordnung nach einer der vorstehend beschriebenen Varianten aufweist.

Außerdem wird ein modularer Multilevelstromrichter mit einer Vielzahl von derartigen Modulen offenbart.

Das beschriebenen Verfahren und die beschriebene Anordnung weisen gleiche beziehungsweise gleichartige Vorteile auf.

Im Folgenden wird die Erfindung anhand von Ausführungsbeispielen näher erläutert. Gleiche Bezugszeichen verweisen dabei auf gleiche oder gleich wirkende Elemente. Dazu ist in
- Figur 1: ein Ausführungsbeispiel eines Stromrichters, der eine Vielzahl von Modulen aufweist, in
- Figur 2: ein Ausführungsbeispiel eines Moduls, in
- Figur 3: ein weiteres Ausführungsbeispiel eines Moduls, in
- Figur 4: ein Ausführungsbeispiel einer Hochspannungs-Gleichstrom-Übertragungsanlage, in
- Figur 5: ein Ausführungsbeispiel einer Blindleistungs-Kompensationsanlage, in
- Figur 6: ein Ausführungsbeispiel eines Moduls mit einem Thyristor, in
- Figur 7: ein weiteres Ausführungsbeispiel eines Moduls mit einem Thyristor, in
- Figur 8: ein Ausführungsbeispiel eines montierten Thyristors in einer Draufsicht, in
- Figur 9: das Ausführungsbeispiel des montierten Thyristors in einer Seitenansicht, in
- Figur 10: eine beispielhafte Darstellung des Halbleitermaterials des Thyristors im Magnetfeld und in
- Figur 11: ein beispielhafter Verfahrensablauf
dargestellt.

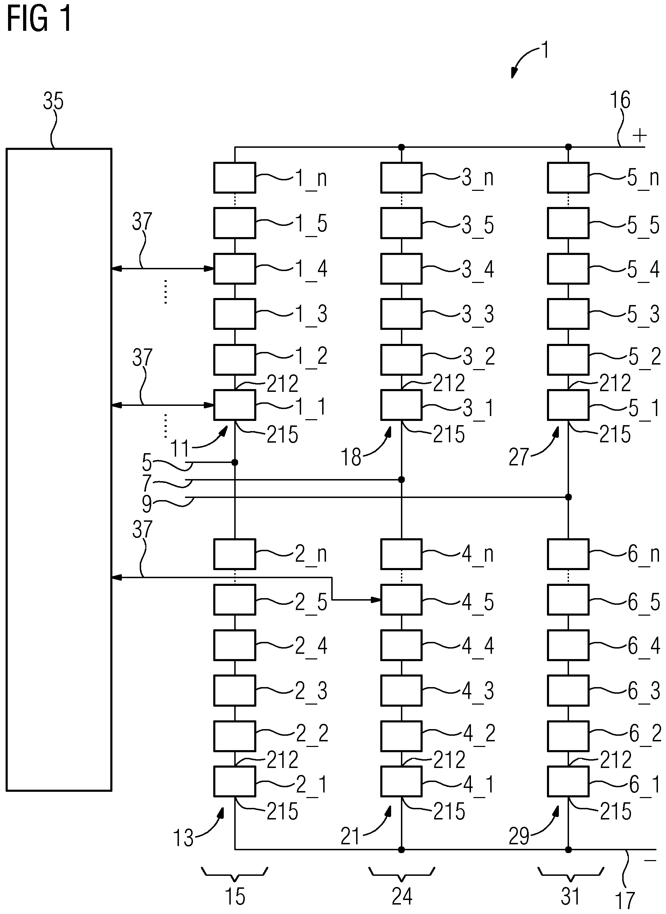

In Figur 1 ist ein Stromrichter 1 in Form eines modularen Multilevelstromrichters 1 (modular multilevel converter, MMC) dargestellt. Dieser Multilevelstromrichter 1 weist einen ersten Wechselspannungsanschluss 5, einen zweiten Wechselspannungsanschluss 7 und einen dritten Wechselspannungsanschluss 9 auf. Der erste Wechselspannungsanschluss 5 ist elektrisch mit einem ersten Phasenmodulzweig 11 und einem zweiten Phasenmodulzweig 13 verbunden. Der erste Phasenmodulzweig 11 und der zweite Phasenmodulzweig 13 bilden ein erstes Phasenmodul 15 des Stromrichters 1. Das dem ersten Wechselspannungsanschluss 5 abgewandte Ende des ersten Phasenmodulzweigs 11 ist mit einem ersten Gleichspannungsanschluss 16 elektrisch verbunden; das dem ersten Wechselspannungsanschluss 5 abgewandte Ende des zweiten Phasenmodulzweigs 13 ist mit einem zweiten Gleichspannungsanschluss 17 elektrisch verbunden. Der erste Gleichspannungsanschluss 16 ist ein positiver Gleichspannungsanschluss; der zweite Gleichspannungsanschluss 17 ist ein negativer Gleichspannungsanschluss.

Der zweite Wechselspannungsanschluss 7 ist mit einem Ende eines dritten Phasenmodulzweigs 18 und mit einem Ende eines vierten Phasenmodulzweigs 21 elektrisch verbunden. Der dritte Phasenmodulzweig 18 und der vierte Phasenmodulzweig 21 bilden ein zweites Phasenmodul 24. Der dritte Wechselspannungsanschluss 9 ist mit einem Ende eines fünften Phasenmodulzweigs 27 und mit einem Ende eines sechsten Phasenmodulzweigs 29 elektrisch verbunden. Der fünfte Phasenmodulzweig 27 und der sechste Phasenmodulzweig 29 bilden ein drittes Phasenmodul 31.

Das dem zweiten Wechselspannungsanschluss 7 abgewandte Ende des dritten Phasenmodulzweigs 18 und das dem dritten Wechselspannungsanschluss 9 abgewandte Ende des fünften Phasenmodulzweigs 27 sind mit dem ersten Gleichspannungsanschluss 16 elektrisch verbunden. Das dem zweiten Wechselspannungsanschluss 7 abgewandte Ende des vierten Phasenmodulzweigs 21 und das dem dritten Wechselspannungsanschluss 9 abgewandte Ende des sechsten Phasenmodulzweigs 29 sind mit dem zweiten Gleichspannungsanschluss 17 elektrisch verbunden.

Jeder Phasenmodulzweig weist eine Mehrzahl von Modulen (1_1, 1_2, 1_3, 1_4 ... 1_n; 2_1 ... 2_n; usw.) auf, welche (mittels ihrer galvanischen Stromanschlüsse) elektrisch in Reihe geschaltet sind. Solche Module werden auch als Submodule bezeichnet. Im Ausführungsbeispiel der Figur 1 weist jeder Phasenmodulzweig n Module auf. Die Anzahl der mittels ihrer galvanischen Stromanschlüsse elektrisch in Reihe geschalteten Module kann sehr verschieden sein, mindestens sind drei Module in Reihe geschaltet, es können aber auch beispielsweise 50, 100 oder mehr Module elektrisch in Reihe geschaltet sein. Im Ausführungsbeispiel ist n = 36: der erste Phasenmodulzweig 11 weist also 36 Module 1_1, 1_2, 1_3, ... 1_36 auf. Die anderen Phasenmodulzweige 13, 18, 21, 27 und 29 sind gleichartig aufgebaut.

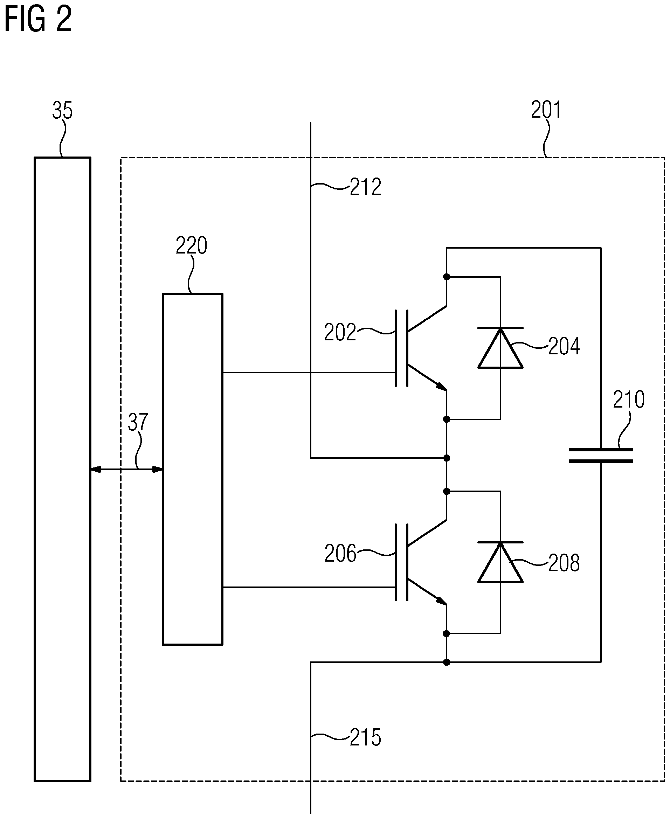

Im linken Bereich der Figur 1 ist schematisch eine Steuereinrichtung 35 für die Module 1_1 bis 6_n dargestellt. Von dieser zentralen Steuereinrichtung 35 werden optische Nachrichten über eine optische Kommunikationsverbindung 37 (zum Beispiel über einen Lichtwellenleiter) zu den einzelnen Modulen übertragen. Die Nachrichtenübertragung zwischen der Steuereinrichtung und einem Modul ist jeweils symbolhaft durch eine Linie 37 dargestellt; die Richtung der Nachrichtenübertragung ist durch die Pfeilspitzen an den Linien 37 symbolisiert. Dies ist am Beispiel der Module 1_1, 1_4 und 4_5 dargestellt; zu den anderen Modulen werden auf die gleiche Art und Weise Nachrichten gesendet beziehungsweise von diesen Modulen Nachrichten empfangen. Beispielsweise sendet die Steuereinrichtung 35 an die einzelnen Module jeweils einen Sollwert zur Höhe der Ausgangsspannung, die das jeweilige Modul bereitstellen soll. In Figur 2 ist beispielhaft der Aufbau eines Moduls 201 dargestellt. Dabei kann es sich beispielsweise um das Modul 1_1 des ersten Phasenmodulzweigs 11 (oder auch um eines der anderen in Figur 1 dargestellten Module) handeln. Das Modul ist als ein Halbbrückenmodul 201 ausgestaltet. Das Modul 201 weist ein erstes ein- und abschaltbares elektronisches Schaltelement 202 (ein- und abschaltbares Schaltelement 202) mit einer ersten antiparallel geschalteten Diode 204 auf. Weiterhin weist das Modul 201 ein zweites ein- und abschaltbares elektronisches Schaltelement 206 (ein- und abschaltbares Schaltelement 206) mit einer zweiten antiparallel geschalteten Diode 208 sowie einen elektrischen Energiespeicher 210 in Form eines Kondensators 210 auf. Das erste elektronische Schaltelement 202 und das zweite elektronische Schaltelement 206 sind jeweils als ein IGBT (insulated-gate bipolar transistor) ausgestaltet. Das erste elektronische Schaltelement 202 ist elektrisch in Reihe geschaltet mit dem zweiten elektronischen Schaltelement 206. Am Verbindungspunkt zwischen den beiden elektronischen Schaltelementen 202 und 206 ist ein erster galvanischer Modulanschluss 212 angeordnet. An dem Anschluss des zweiten Schaltelements 206, welcher dem Verbindungspunkt gegenüberliegt, ist ein zweiter galvanischer Modulanschluss 215 angeordnet. Der zweite Modulanschluss 215 ist weiterhin mit einem ersten Anschluss des Energiespeichers 210 verbunden; ein zweiter Anschluss des Energiespeichers 210 ist elektrisch verbunden mit dem Anschluss des ersten Schaltelements 202, der dem Verbindungspunkt gegenüberliegt.

Der Energiespeicher 210 ist also elektrisch parallel geschaltet zu der Reihenschaltung aus dem ersten Schaltelement 202 und dem zweiten Schaltelement 206. Durch entsprechende Ansteuerung des ersten Schaltelements 202 und des zweiten Schaltelements 206 durch die modulinterne elektronische Modulsteuereinrichtung 220 kann erreicht werden, dass zwischen dem ersten galvanischen Modulanschluss 212 und dem zweiten galvanischen Modulanschluss 215 entweder die Spannung des Energiespeichers 210 ausgegeben wird oder keine Spannung ausgegeben wird (d.h. eine Nullspannung ausgegeben wird). Durch Zusammenwirken der Module der einzelnen Phasenmodulzweige kann so die jeweils gewünschte Ausgangsspannung des Stromrichters erzeugt werden.

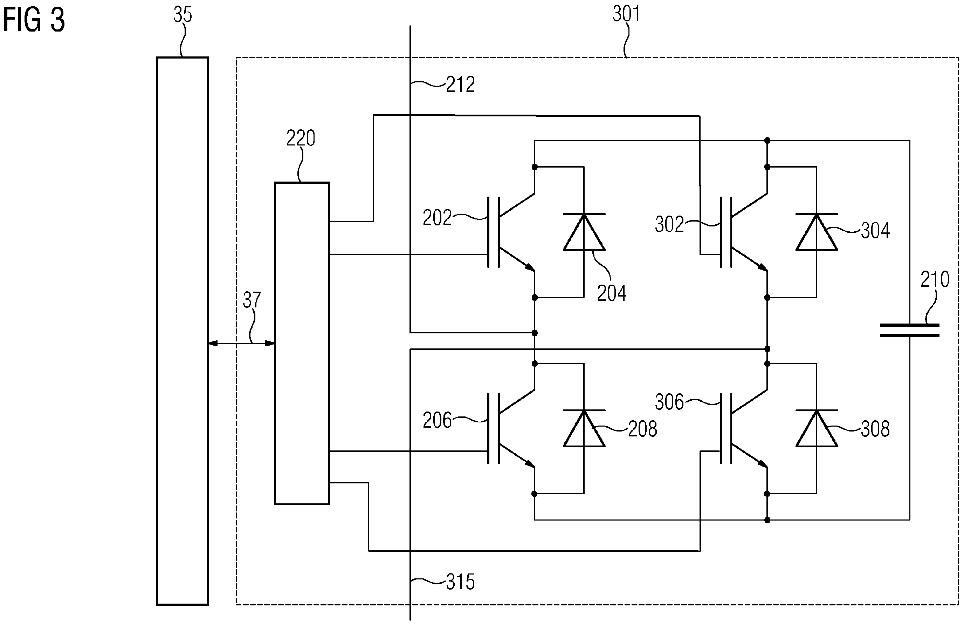

In Figur 3 ist ein weiteres Ausführungsbeispiel eines Moduls 301 des modularen Multilevel-Stromrichters 1 dargestellt. Bei diesem Modul 301 kann es sich beispielsweise um das Modul 1_2 (oder auch um eines der anderen in Figur 1 dargestellten Module) handeln. Neben dem bereits aus Figur 2 bekannten ersten Schaltelement 202, zweiten Schaltelement 206, erster Diode 204, zweiter Diode 208 und Energiespeicher 210 weist das in Figur 3 dargestellte Modul 301 ein drittes ein- und abschaltbares elektronisches Schaltelement 302 mit einer antiparallel geschalteten dritten Diode 304 sowie ein viertes ein- und abschaltbares elektronisches Schaltelement 306 mit einer antiparallel geschalteten vierten Diode 308 auf. Das dritte ein- und abschaltbare Schaltelement 302 und das vierte ein- und abschaltbare Schaltelement 306 sind jeweils als ein IGBT ausgestaltet. Im Unterschied zur Schaltung der Figur 2 ist der zweite galvanische Modulanschluss 315 nicht mit dem zweiten Schaltelement 206 elektrisch verbunden, sondern mit einem Mittelpunkt einer elektrischen Reihenschaltung aus dem dritten Schaltelement 302 und dem vierten Schaltelement 306.

Das Modul 301 der Figur 3 ist ein sogenanntes Vollbrücken-Modul 301. Dieses Vollbrücken-Modul 301 zeichnet sich dadurch aus, dass bei entsprechender Ansteuerung der vier Schaltelemente zwischen dem ersten galvanischen Modulanschluss 212 und dem zweiten galvanischen Modulanschluss 315 wahlweise entweder die positive Spannung des Energiespeichers 210, die negative Spannung des Energiespeichers 210 oder eine Spannung des Wertes Null (Nullspannung) ausgegeben werden kann. Somit kann also mittels des Vollbrückenmoduls 301 die Polarität der Ausgangsspannung umgekehrt werden. Der Stromrichter 1 kann entweder nur Halbbrücken-Module 201, nur Vollbrücken-Module 301 oder auch Halbbrücken-Module 201 und Vollbrücken-Module 301 aufweisen. Über den ersten galvanischen Modulanschluss 212 und den zweiten galvanischen Modulanschluss 215, 315 fließen große elektrische Ströme des Stromrichters.

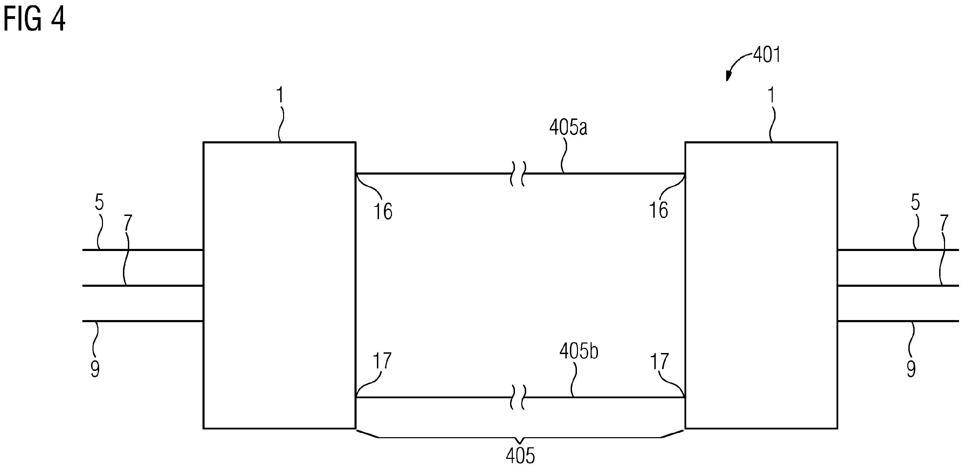

In Figur 4 ist schematisch ein Ausführungsbeispiel einer Hochspannungs-Gleichstrom-Übertragungsanlage 401 dargestellt. Diese Hochspannungs-Gleichstrom-Übertragungsanlage 401 weist zwei Stromrichter 1 auf, wie sie in Figur 1 dargestellt sind. Diese beiden Stromrichter 1 sind gleichspannungsseitig über eine Hochspannungs-Gleichstrom-Verbindung 405 elektrisch miteinander verbunden. Dabei sind die beiden positiven Gleichspannungsanschlüsse 16 der Stromrichter 1 mittels einer ersten Hochspannungs-Gleichstrom-Leitung 405a elektrisch miteinander verbunden; die beiden negativen Gleichspannungsanschlüsse 17 der beiden Stromrichter 1 sind mittels einer zweiten Hochspannungs-Gleichstrom-Leitung 405b elektrisch miteinander verbunden. Mittels einer derartigen Hochspannungs-Gleichstrom-Übertragungsanlage 401 kann elektrische Energie über weite Entfernungen übertragen werden; die Hochspannungs-Gleichstrom-Verbindung 405 weist dann eine entsprechende Länge auf.

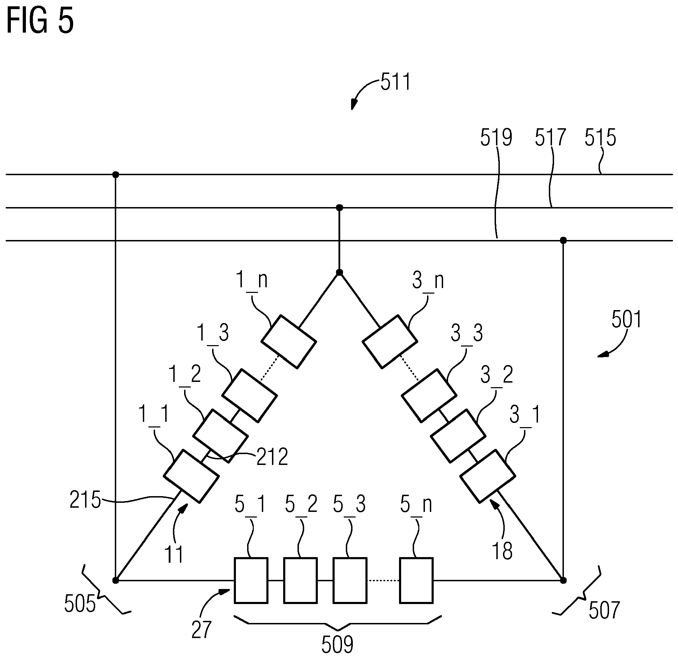

In Figur 5 ist ein Ausführungsbeispiel eines Stromrichters 501 dargestellt, welcher als ein Blindleistungskompensator 501 dient. Dieser Stromrichter 501 weist lediglich die drei Phasenmodulzweige 11, 18 und 27 auf, welche drei Phasenmodule 505, 507 und 509 des Stromrichters bilden. Die Anzahl der Phasenmodule 505, 507 und 509 entspricht der Anzahl der Phasen eines Wechselspannungsnetzes 511, an das der Stromrichter 501 angeschlossen ist.

Die drei Phasenmodulzweige 11, 18 und 27 sind sternförmig miteinander verbunden. Das dem Sternpunkt entgegengesetzte Ende der drei Phasenmodulzweige ist mit jeweils einer Phasenleitung 515, 517 und 519 des dreiphasigen Wechselspannungsnetzes 511 elektrisch verbunden. (Die drei Phasenmodule 505, 507 und 509 können in einem anderen Ausführungsbeispiel anstelle in Sternschaltung auch in Dreieckschaltung geschaltet sein.) Der Stromrichter 501 kann das Wechselspannungsnetz 511 mit Blindleistung versorgen oder Blindleistung aus dem Wechselspannungsnetz 511 entnehmen.

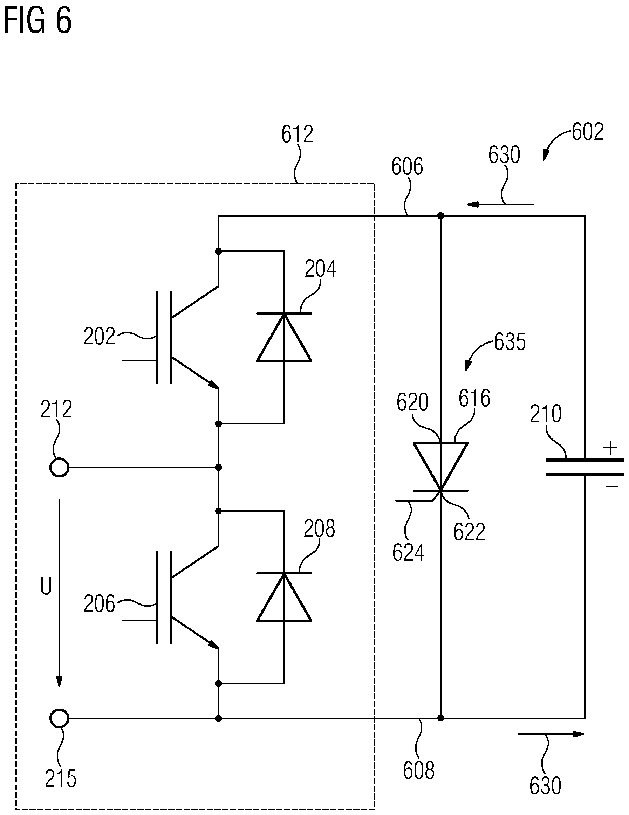

In Figur 6 ist eine Anordnung 602 mit dem elektrischen Energiespeicher 210 dargestellt. Der Energiespeicher 210 ist im Ausführungsbeispiel ein elektrischer Kondensator 210, genauer gesagt ein unipolarer elektrischer Kondensator (mit einem positiven Kondensatoranschluss (+) und einem negativen Kondensatoranschluss (-)). Der Energiespeicher 210 kann aber in anderen Ausführungsbeispielen auch ein anderer Typ Kondensator, eine elektrische Batterie oder ein elektrischer Akkumulator sein. Bei der Anordnung 602 kann es sich beispielsweise um das Modul 1_2 (oder auch um eines der anderen in Figur 1 dargestellten Module) handeln. Die Anordnung 602 weist den grundsätzlichen Aufbau des in Figur 2 dargestellten Moduls 201 auf.

Der elektrische Energiespeicher 210 ist mittels eines ersten elektrischen Leiters 606 (erste elektrische Verbindung 606) und eines zweiten elektrischen Leiters 608 (zweite elektrische Verbindung 608) mit einer elektronischen Schaltung 612 (leistungselektronische Schaltung 612) verbunden. Der erste elektrische Leiter 606 ist ein positiver elektrischer Leiter; der zweite elektrische Leiter 608 ist ein negativer elektrischer Leiter.

Die elektronische Schaltung 612 weist das erste elektronische Schaltelement 202, das zweite elektronische Schaltelement 206, die erste antiparallel geschaltete Diode 204 und die zweite antiparallel geschaltete Diode 208 auf, welche bereits aus der Figur 2 bekannt sind. Weiterhin weist die Anordnung 602 einen Thyristor 616 auf, welcher parallel zu dem elektrischen Energiespeicher 210 geschaltet ist. Eine Anode 620 (Anodenanschluss 620) des Thyristors ist elektrisch mit dem ersten elektrischen Leiter 606 verbunden. Eine Kathode 622 (Kathodenanschluss 622) des Thyristors ist elektrisch mit dem zweiten elektrischen Leiter 608 verbunden. Ein Gate 624 (Gateanschluss 624) des Thyristors ist im Ausführungsbeispiel unbeschaltet. Mit anderen Worten ist dieses Gate 624 offen, das heißt, nicht mit anderen Bauelementen verbunden. Der Thyristor 616 ist ein Schutzthyristor 616 zum Führen eines Entladestroms 630 des elektrischen Energiespeichers 210 im Fehlerfall. Der Thyristor 616 leitet im Fehlerfall den Entladestrom 630 des elektrischen Energiespeichers 210 an der elektronischen Schaltung 612 vorbei und schützt damit die elektronische Schaltung 612 vor dem (im Allgemeinen sehr hohen) Entladestrom 630 des elektrischen Energiespeichers 210. Ein solcher Thyristor wird auch als ein Crowbar-Thyristor bezeichnet. Der Entladestrom 630 kann auch als ein kurzschlussartiger Entladestrom 630 oder als ein Kurzschlussstrom 630 bezeichnet werden.

In der Anordnung 602 läuft im Fehlerfall folgendes Verfahren ab: Als Ausgangspunkt sei angenommen, dass der elektrische Energiespeicher 210 aufgeladen ist. Der Thyristor 616 ist ausgeschaltet (nicht gezündet), das heißt, der Thyristor 616 sperrt den Stromfluss. Daraufhin tritt in der elektronischen Schaltung 612 ein Fehler auf: Beispielsweise werden (unerwünschterweise) das erste elektronische Schaltelement 202 und das zweite elektronische Schaltelement 206 gleichzeitig elektrisch leitend (es tritt ein sogenannter Brückenkurzschluss in der durch das erste elektronische Schaltelement 202 und das zweite elektronische Schaltelement 206 gebildeten Halbbrücke auf). Dadurch wird der elektrische Energiespeicher 210 kurzgeschlossen und der Entladestrom 630 beginnt plötzlich zu fließen.

Der Entladestrom 630 fließt zunächst ausgehend von dem Energiespeicher 210 über den ersten elektrischen Leiter 606 zu der elektronischen Schaltung 612. Dort fließt der Entladestrom 630 über das erste elektronische Schaltelement 202 und das zweite elektronische Schaltelement 206. Danach fließt der Entladestrom 630 über den zweiten elektrischen Leiter 608 zurück zum Energiespeicher 210. Dabei weist der Ladestrom im ersten elektrischen Leiter 606 und in dem zweiten elektrischen Leiter 608 jeweils entgegengesetzte Richtungen auf. Der Entladestrom 630 wird lediglich begrenzt durch Streukapazitäten und ohmsche Widerstände, welche in dem ersten elektrischen Leiter, dem zweiten elektrischen Leiter sowie der elektronischen Schaltung 612 auftreten. Daher steigt der Entladestrom 630 relativ schnell an.

Aufgrund des (ansteigenden) Entladestroms 630 wird um den ersten elektrischen Leiter 606 herum ein sich zeitlich änderndes Magnetfeld erzeugt. Aufgrund des Entladestroms 630 wird auch um den zweiten elektrischen Leiter 608 herum ein sich zeitlich änderndes Magnetfeld erzeugt. Diese beiden Magnetfelder überlagern sich und durchdringen beide den Thyristor 616 und damit das Halbleitermaterial des Thyristors 616. Der Thyristor ist nämlich räumlich benachbart zu dem ersten elektrischen Leiter und dem zweiten elektrischen Leiter angeordnet. (Der Thyristor 616 weist ein Außengehäuse aus anti-magnetischem Material auf, welches das den Thyristor 616 durchdringende Magnetfeld nicht oder nur wenig behindert.)

Durch das sich zeitlich ändernde Magnetfeld wird in dem Halbleitermaterial des Thyristors ein Strom induziert, beispielsweise ein Wirbelstrom. Dieser Strom wirkt als ein Gatestrom (interner Gatestrom, innerer Gatestrom) oder Zündstrom und bewirkt ein Einschalten des Thyristors 616 (d.h. ein Zünden des Thyristors 616). Aufgrund des Einschaltens des Thyristors 616 fließt jetzt der Entladestrom 630 nicht mehr über die elektronische Schaltung 612, sondern über den Thyristor 616. Genauer gesagt fließt jetzt der Entladestrom 630 vom Energiespeicher 210 über einen Teil des ersten elektrischen Leiters 606 zur Anode 620 des Thyristors und von der Kathode 622 des Thyristors über einen Teil des zweiten elektrischen Leiters 608 zurück zum Energiespeichers 210. Der Entladestrom 630 fließt über den Thyristor 616, weil der Thyristor 616 elektrisch niederinduktiv mit dem Energiespeicher 210 verbunden ist. Das heißt, die elektrische Verbindung zwischen dem Thyristor 616 und dem Energiespeicher 210 weist eine geringere elektrische Induktivität auf als der erste elektrische Leiter 606 und der zweite elektrische Leiter 608, welche den Energiespeicher 210 mit der elektronischen Schaltung 612 verbinden.

Der Thyristor 616 wird also durch den induzierten Strom (Wirbelstrom) eingeschaltet. Das Gate 624 kann dabei unbeschaltet sein. Das Gate 624 braucht nicht einmal aus dem Thyristor herausgeführt zu sein. Der Thyristor wird insbesondere erst dann durch den induzierten Strom (Gatestrom oder Zündstrom) eingeschaltet, wenn die zeitliche Änderung des Magnetfelds einen Schwellwert überschreitet. Entscheidend ist dabei die zeitliche Änderung des Magnetfelds am Ort des Halbleitermaterials des Thyristors. Am Halbleitermaterial des Thyristors lassen sich besonders große zeitliche Änderungen des Magnetfeldes realisieren, wenn der Thyristor sehr nahe an dem ersten elektrischen Leiter 606 und/ oder an dem zweiten elektrischen Leiter 608 angeordnet ist. Große zeitliche Änderungen des Magnetfelds lassen sich auch dadurch realisieren, dass der Abstand zwischen dem ersten elektrischen Leiter 606 und dem zweiten elektrischen Leiter 608 gering ist und dass der Thyristor 616 in einem Zwischenraum 635 zwischen dem ersten elektrischen Leiter 606 und dem zweiten elektrischen Leiter 608 angeordnet ist. Mit anderen Worten gesagt, wird durch den induzierten Strom (Gatestrom oder Zündstrom) der Thyristor eingeschaltet, wenn die zeitliche Änderung des Entladestroms (in dem ersten elektrischen Leiter 606 und/oder dem zweiten elektrischen Leiter 608) einen Schwellwert überschreitet. Dieser Schwellwert kann beispielsweise bei einem Wert zwischen 5 und 50 kA pro µs liegen.

Durch den durch den Thyristor 616 fließenden Entladestrom 630 kann der Thyristor 616 thermisch überlastet und dadurch zerstört werden. Im Fehlerfall wirkt also der Thyristor als ein Opferelement, um die elektronische Schaltung 612 vor dem Entladestrom 630 zu schützen. Nach Auftreten eines Fehlers (d.h. nach Ableiten des Entladestroms 630 über den Thyristor 616) muss also der Thyristor 616 ausgetauscht werden. Insbesondere weist der Thyristor 616 eine sogenannte conduct-on-fail-Eigenschaft auf, das heißt, im Fehlerfall (und auch bei einer Zerstörung durch Überlastung) bleibt der Thyristor 616 leitfähig und ist daher in der Lage, den Entladestrom 630 bis zu dessen Abklingen zu führen. Solche Thyristoren mit conduct-on-fail-Eigenschaft sind kommerziell verfügbar.

Als Alternative zu dem unbeschalteten (oder sogar gar nicht aus dem Thyristor herausgeführten) Gate kann das Gate 624 auch mittels einer konstanten Impedanz ungleich Null abgeschlossen sein. Als weitere Alternative kann an das Gate 624 aber auch eine Ansteuereinheit angeschlossen sein, die bei einem entladefreien Fehler (also bei einem Fehler, der nicht mit einem Entladen des Energiespeichers 210 bzw. mit einem kurzschlussartigen Entladestrom 630 des Energiespeichers einhergeht) einen Gatestrom in das Gate 624 des Thyristors einspeist. Ein derartiger entladefreier Fehler kann beispielsweise ein Überladen des Energiespeichers 210 sein, was zwar nicht unmittelbar zu einem kurzschlussartigen Entladestrom 630 führt, aber dennoch verhindert werden sollte.

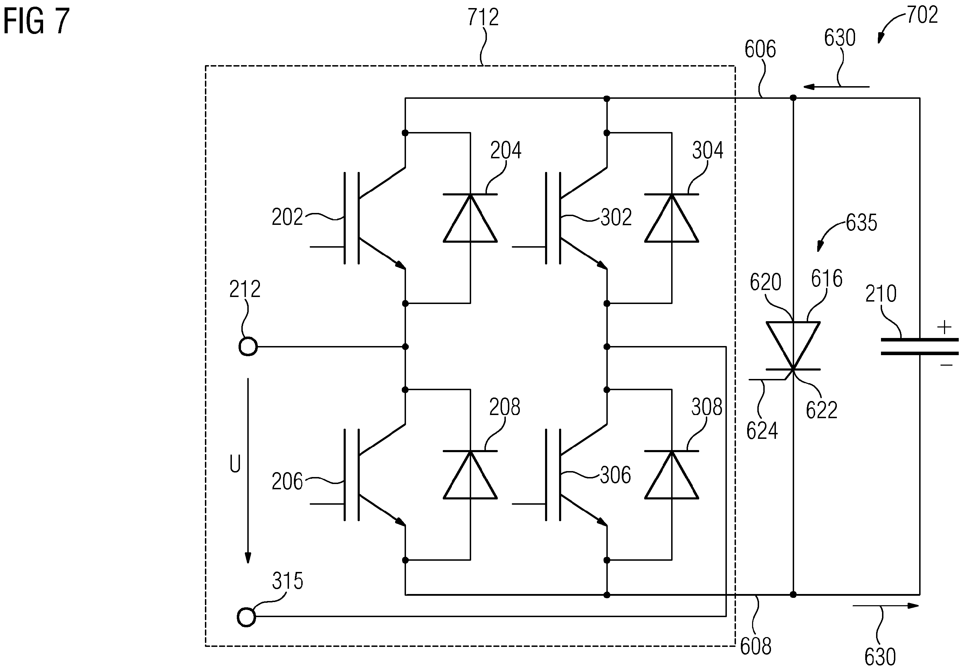

In Figur 7 ist ein weiteres Ausführungsbeispiel einer Anordnung 702 dargestellt. Bei der Anordnung 702 kann es sich beispielsweise um das Modul 1_2 (oder auch um eines der anderen in Figur 1 dargestellten Module) handeln. Die Anordnung 702 weist den grundsätzlichen Aufbau des in Figur 3 dargestellten Moduls 301 auf.

Die Anordnung 702 unterscheidet sich von der Anordnung 602 der Figur 6 lediglich dadurch, dass die Anordnung 702 eine elektronische Schaltung 712 aufweist, die sich von der elektronischen Schaltung 612 unterscheidet: Die elektronische Schaltung 712 weist zusätzlich ein drittes elektronisches Schaltelement 302 mit einer dritten antiparallel geschalteten Diode 304 sowie ein viertes elektronisches Schaltelement 306 mit einer vierten antiparallel geschalteten Diode 308 auf. Das erste elektronische Schaltelement 202, das zweite elektronische Schaltelement 206, das dritte elektronische Schaltelement 302 und das vierte elektronische Schaltelement 306 sind dabei in einer Vollbrückenschaltung geschaltet. Bei der elektronischen Schaltung 712 kann beispielsweise ein Fehler auftreten, der zur Folge hat, dass das dritte elektronische Schaltelement 302 und das vierte elektronische Schaltelement 306 gleichzeitig elektrisch leitend werden. Dann wird durch das dritte Schaltelement 302 und das vierte Schaltelement 306 der Energiespeicher 210 elektrisch kurzgeschlossen und der Entladestrom 630 beginnt, vom Energiespeicher 210 zu der elektronischen Schaltung 712 zu fließen. Der weitere Ablauf des Verfahrens entspricht dem im Zusammenhang mit Figur 6 erläuterten Verfahren.

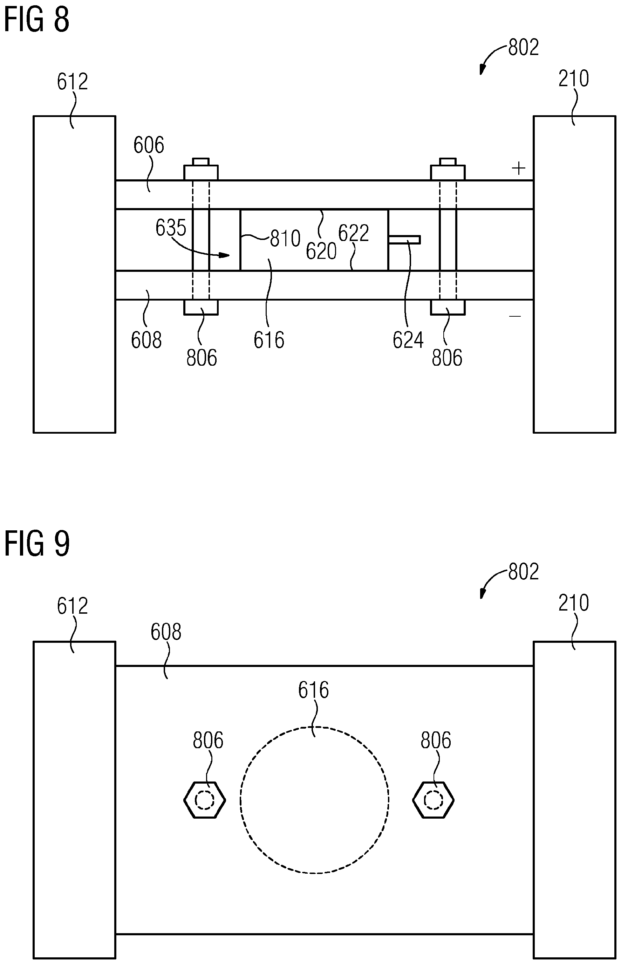

In Figur 8 ist ein Ausführungsbeispiel einer Anordnung 802 des Thyristors 616 zwischen dem ersten elektrischen Leiter 606 und dem zweiten elektrischen Leiter 608 dargestellt. Der erste elektrische Leiter 606 und der zweite elektrische Leiter 608 sind hier als eine erste Stromschiene 606 und eine zweite Stromschiene 608 ausgestaltet. Die erste elektrische Stromschiene 606 und die zweite elektrische Stromschiene 608 weisen jeweils ein Flachprofil auf. Im linken Teil der Figur 8 ist die elektronische Schaltung 612 schematisch als ein Block 612 dargestellt; im rechten Teil der Figur 8 ist der Energiespeicher 210 schematisch als ein Block 210 dargestellt. Anstelle der elektronischen Schaltung 612 kann auch die elektronische Schaltung 712 verwendet werden.

Der erste elektrische Leiter 606 (erste elektrische Stromschiene 606) verbindet den Energiespeicher 210 mit der elektronischen Schaltung 612. Der zweite elektrische Leiter 608 (zweite elektrische Stromschiene 608) verbindet den Energiespeicher 210 mit der elektronischen Schaltung 612. Zwischen dem ersten elektrischen Leiter 606 und dem zweiten elektrischen Leiter 608 ist der Thyristor 616 mechanisch verspannt. Damit befindet sich der Thyristor 616 in dem Zwischenraum 635 zwischen dem ersten elektrischen Leiter 606 und dem zweiten elektrischen Leiter 608. Die Anode 620 des Thyristors 616 liegt an dem ersten elektrischen Leiter 606, die Kathode 622 des Thyristors 616 liegt an dem zweiten elektrischen Leiter 608 an. Die Verspannung wird mittels einer Spannvorrichtung 806 realisiert. Die Spannvorrichtung 806 weist im Ausführungsbeispiel zwei Bolzen auf, die mittels jeweils einer Mutter den ersten elektrischen Leiter 606, den Thyristor 616 und den zweiten elektrischen Leiter 608 mechanisch verspannen. Der erste elektrische Leiter 606, der Thyristor 616 und der zweite elektrische Leiter 608 bilden einen Spannverband. Dieser Spannverband beziehungsweise die mechanische Verspannung bewirken einen guten elektrischen Kontakt zwischen dem ersten elektrischen Leiter 60 und dem Thyristor 616 sowie einen guten elektrischen Kontakt dem zweiten elektrischen Leiter 608 und dem Thyristor 616. Außerdem ist die Anordnung aufgrund der Verspannung beziehungsweise des Spannverbandes mechanisch so stabil, dass die Anordnung die aufgrund der großen Entladestroms wirkenden Stromkräfte zuverlässig aufnehmen kann.

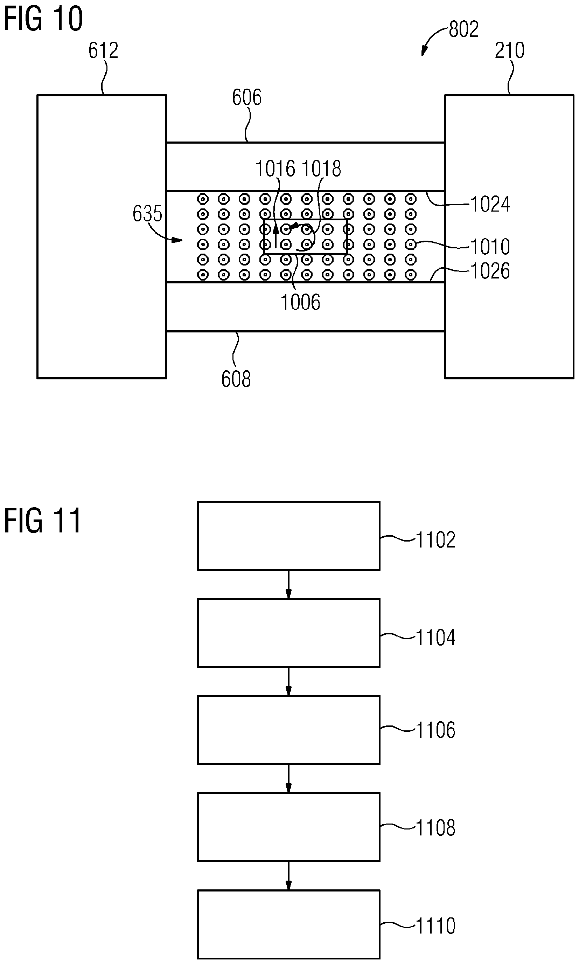

Es ist gut zu erkennen, dass die Bauhöhe des Thyristors 616 in etwa dem Abstand zwischen dem ersten elektrischen Leiter 606 und dem zweiten elektrischen Leiter 608 entspricht. Die Anode 620 und die Kathode 622 bilden jeweils eine Spannfläche des Thyristors 616. Die Feldlinien der magnetischen Flussdichte B verlaufen parallel zu den Spannflächen des Thyristors 616 (in Figur 8 nicht dargestellt; vgl. Figur 10). Das elektrische Feld (E-Feld) steht senkrecht zum Feld der magnetischen Flussdichte B, ist in den Figuren jedoch nicht dargestellt. Beispielsweise ist denkbar, dass mittels eines Entladestroms 630, der sehr schnell von Null auf ca. 20 kA ansteigt, der Thyristor 616 eingeschaltet werden kann, das heißt, ein Entladestrom mit einem Maximalwert größer als ca. 20 kA, der in sehr kurzer Zeit (kleiner 1µs - 2ps) auf seinen Maximalwert ansteigt, führt zu Einschaltung des Thyristors 616.

Der Thyristor 616 hat im Ausführungsbeispiel der Figur 8 die Form einer Scheibenzelle; der Thyristor 616 weist ein Scheibenzellengehäuse 810 auf. Mit anderen Worten hat der Thyristor eine scheibenförmige Gestalt, wobei die Grundfläche die Kathode und die Deckfläche die Anode bildet. Mit solchen scheibenzellenförmigen Thyristoren lassen sich insbesondere mechanisch stabile Spannverbände realisieren. Die Darstellung der Figur 8 zeigt außerdem, dass das Gate 624 des Thyristors unbeschaltet ist. Im Unterschied zur Darstellung der Figur 8 braucht das Gate 624 gar nicht aus dem Gehäuse 810 des Thyristors 616 herausgeführt zu werden, weil es unbeschaltet ist.

In Figur 9 ist die Anordnung 802 gemäß der Figur 8 in einer Seitenansicht dargestellt. Hierbei ist mittels einer strichlierten Linie der Umfang des scheibenzellenförmigen Thyristors 616 angedeutet.

In Figur 10 ist die Anordnung 802 in einer Draufsicht dargestellt, ähnlich der Darstellung der Figur 8. Jedoch sind in Figur 10 die Spannvorrichtung 806, das Gehäuse des Thyristors 616 und die elektrischen Verbindungen zwischen der Anode und dem ersten elektrischen Leiter und zwischen der Kathode und dem zweiten elektrischen Leiter weggelassen worden; es ist lediglich das Halbleitermaterial 1006 des Thyristors 616 dargestellt. Dieses Halbleitermaterial 1006 bildet eine Scheibe 1006 (scheibenförmiges Halbleitermaterial 1006, Halbleitermaterial-Scheibe 1006). Die Scheibe 1006 ist im Querschnitt dargestellt. In der Seitenansicht hat die Scheibe 1006 eine kreisförmige Gestalt ähnlich wie in Figur 9 der Umfang des Thyristors 616. Das Halbleitermaterial 1006 ist aus Gründen der besseren Darstellbarkeit übertrieben dick dargestellt. Die relevanten Halbleiterstrukturen (insbesondere Siliziumstrukturen) in diesem Halbleitermaterial 1006 sind oftmals sehr dünn, zum Beispiel nur mehrere 100 µm dick.

Weiterhin sind die Feldlinien des Magnetfelds 1010 dargestellt, welche sich im Zwischenraum 635 zwischen dem ersten elektrischen Leiter 606 und dem zweiten elektrischen Leiter 608 ausbilden (Feldlinien 1010 der magnetischen Flußdichte B). Die Feldlinien 1010 des Magnetfelds kommen aus der Zeichenebene heraus und weisen auf den Betrachter zu; der Betrachter blickt sozusagen von vorn auf die Feldlinienspitze. Da der erste elektrische Leiter 606 und der zweite elektrische Leiter 608 plattenförmig sind, bilden sich im Zwischenraum 635 zwischen dem ersten elektrischen Leiter 606 und dem zweiten elektrischen Leiter 608 parallele Feldlinien 1010 aus. Die Feldlinien 1010 durchdringen das Halbleitermaterial 1006 des Thyristors. Aufgrund des sich zeitlich ändernden Magnetfelds 1010 wird in dem Halbleitermaterial 1006 eine Spannung 1016 induziert, welche das Fließen eines Stroms 1018 (Wirbelstrom 1018) in dem Halbleitermaterial 1006 des Thyristors zur Folge hat. Die Spannung 1016 sowie der Strom 1018 sind hier nur schematisch dargestellt. Der induzierte Strom 1018 wirkt als ein Gatestrom 1018 des Thyristors oder als ein Zündstrom des Thyristors und schaltet den Thyristor 616 ein (d.h. der Strom 1018 zündet den Thyristor 616).

Der erste elektrische Leiter 606 weist eine erste ebene Außenfläche 1024 auf. Der zweite elektrische Leiter 608 weist eine zweite ebene Außenfläche 1026 auf. Die erste ebene Außenfläche 1024 und die zweite eben Außenfläche 1026 sind parallel zueinander angeordnet. Das scheibenförmige Halbleitermaterial 1006 des Thyristors 616 ist parallel zu der ersten Außenfläche 1024 und ebenfalls parallel zu der zweiten Außenfläche 2026 angeordnet. Diese Anordnung des Halbleitermaterials 1006 ermöglicht einen kompakten und mechanisch stabilen Aufbau der Anordnung 802. Außerdem entsteht (durch den dadurch möglichen geringen Abstand zwischen dem ersten elektrischen Leiter 606 und dem zweiten elektrischen Leiter 608) eine große zeitliche Änderung des Magnetfelds am Ort des Halbleitermaterials 1006.

Mit anderen Worten gesagt, stellt die Scheibe 1006 (der Silizium-Wafer 1006 des Thyristors) ein leitfähiges Material dar. Sobald die Scheibe mit dem zeitlich ändernden Magnetfeld B 1010 durchsetzt ist, wird in der Fläche der Scheibe der Strom 1018 (insbesondere ein Wirbelstrom) erzeugt. Dieser Strom führt dazu, dass der Thyristor 616 zündet, das heißt, eingeschaltet wird. Je höher der fließende kurzschlussartige Entladestrom 630 ist, desto größer ist auch die dadurch erzeugte magnetische Flussdichte B.

In Figur 11 ist nochmals das Verfahren zum Entladen des Energiespeichers mittels eines Ablaufdiagramms dargestellt. Ausgangspunkt des Verfahrens ist, dass der Energiespeicher aufgeladen ist und der Thyristor sich im ausgeschalteten Zustand (sperrenden Zustand) befindet.

### Verfahrensschritt 1102:

Nach Auftreten eines Fehlers in der elektronischen Schaltung 612 Beginn des Fließens des Entladestroms 630 des Energiespeichers 210. Der Entladestrom 630 fließt vom Energiespeicher 210 über den ersten elektrischen Leiter 606 zur elektronischen Schaltung 612 und über den zweiten elektrischen Leiter 608 zum Energiespeicher 210 zurück.

### Verfahrensschritt 1104:

Erzeugen eines sich zeitlich ändernden Magnetfelds 1010 um den ersten elektrischen Leiter 606 und/oder um den zweiten elektrischen Leiter 608 herum aufgrund des ansteigenden Entladestroms 630, wobei das Halbleitermaterial 1006 von dem Magnetfeld 1010 durchdrungen wird.

### Verfahrensschritt 1106:

Induzieren eines Stroms 1018 in dem Halbleitermaterial 1006 des Thyristors 616 durch das sich zeitlich ändernde Magnetfeld 1010. Der Strom 1018 kann als Gatestrom oder als Zündstrom des Thyristors wirken.

### Verfahrensschritt 1008:

Einschalten des Thyristors 616 durch den induzierten Strom 1018. Daraufhin fließt der Entladestrom 630 des Energiespeichers 210 durch den Thyristor 616 und wird dadurch an der elektronischen Schaltung 612 vorbeigeleitet.

### Verfahrensschritt 1110:

Abklingen des Entladestroms 630 mit zunehmender Entladung des Energiespeichers 210.

Es wurde ein Verfahren und eine Anordnung beschrieben, bei denen das in den Thyristor eingekoppelte Magnetfeld (genauer gesagt, die eingekoppelte magnetische Flussdichte B) den gesamten Thyristor durchsetzt und in der dünnen Halbleiterstruktur/Halbleitermaterial des Thyristors einen induzierten Strom (Wirbelstrom) erzeugt. Dieser Strom reicht ab einem Schwellwert der zeitlichen Änderung des Magnetfeldes (dB/dt) aus, um einen Gatestrom (oder einen Zündstrom) in dem Halbleitermaterial fließen zu lassen und dadurch den Thyristor einzuschalten (ohne dass dazu ein externer Gatestrom von einer externen elektronischen Auswerteschaltung notwendig ist). Eine externe Ansteuerung des Gates ist also nicht notwendig, die Fehlererkennung/Kurzschlusserkennung ist dem Thyristor innewohnend und funktioniert, solange der Thyristor intakt ist. Dies ist ein großer Vorteil, da ein Funktionstest von Auswerteschaltungen bei Energiespeichern großer Kapazität in der Praxis schwierig und aufwendig ist. Insbesondere haben die Anordnung und das Verfahren eine niedrige Ausfallrate (FIT-Rate), die im Wesentlichen der Ausfallrate von Thyristoren entspricht. Diese Ausfallrate ist bei Thyristoren sehr niedrig.

Bei der beschriebenen Anordnung und dem beschriebenen Verfahren werden der kurzschlussartige Entladestrom 630 des Energiespeichers zur verzögerungsfreien Zündung des Thyristors genutzt, ohne dass dafür eine Detektionsschaltung beziehungsweise Auswerteschaltung notwendig ist, welche immer einen Zeitverzug mit sich bringen würde. Die technische Realisierung mittels lediglich eines Thyristors ist extrem einfach und kostengünstig. Bei der Zündung des Thyristors kann dieser (je nach Höhe der zu beherrschenden Energien des Energiespeichers) zerstört werden und muss gegebenenfalls bei einer späteren Wartung ersetzt werden. Für den Thyristor kann ein vergleichsweise einfaches Dioden-Scheibenzellen-Gehäuse verwendet werden, da der Gate-Anschluss 624 nicht gebraucht wird und folglich auch nicht aus dem Gehäuse herausgeführt zu werden braucht.

Bei der beschriebenen Anordnung und dem beschriebenen Verfahren werden keine nennenswerten thermischen Verluste erzeugt, was die Energieeffizienz deutlich verbessert im Vergleich zu Schutzelementen, die auch bei Normalbetrieb Durchlass- oder Schaltverluste erzeugen. Dadurch können die elektrischen Verluste von Anlagen, welche eine Vielzahl der beschriebenen Anordnungen aufweisen, (wie beispielsweise Hochspannungs-Gleichstrom-Übertragungsanlagen) gering gehalten werden, was zu einer deutlichen Kosteneinsparung führt.

Es wurde ein Verfahren und eine Anordnung beschrieben, mit denen ein elektrischer Energiespeicher, insbesondere im Falle eines Kurzschlusses, sicher und zuverlässig entladen werden kann. Dazu sind vorteilhafterweise außer einem Thyristor keine weiteren Bauelemente notwendig. Dies ermöglicht einen extrem einfachen und zuverlässigen Schutz der elektronischen Schaltung von dem Entladestrom des Energiespeichers.

## Patentansprüche

1. Verfahren zum Entladen eines elektrischen Energiespeichers (210), der mittels eines ersten elektrischen Leiters (606) und eines zweiten elektrischen Leiters (608) mit einer elektronischen Schaltung (612) verbunden ist, wobei ein Thyristor (616) zum Entladen des Energiespeichers (210) vorgesehen ist, wobei bei dem Verfahren
- aufgrund eines in der elektronischen Schaltung (612) aufgetretenen Fehlers ein Entladestrom (630) des Energiespeichers (210) von dem Energiespeicher (210) über den ersten elektrischen Leiter (606) zu der elektronischen Schaltung (612) und über zweiten elektrischen Leiter (608) zurück zu dem Energiespeicher (210) zu fließen beginnt,
- aufgrund des Entladestroms (630) um den ersten elektrischen Leiter (606) und den zweiten elektrischen Leiter (608) herum ein sich zeitlich änderndes Magnetfeld (1010) erzeugt wird, welches das Halbleitermaterial (1006) des Thyristors (616) durchdringt,
- durch das sich zeitlich ändernde Magnetfeld (1010) in dem Halbleitermaterial (1006) des Thyristors (616) ein Strom (1018) induziert wird,
**dadurch gekennzeichnet, dass** durch
diesen induzierten Strom (1018) der Thyristor (616) eingeschaltet wird.

2. Verfahren nach Anspruch 1,
**dadurch gekennzeichnet, dass**
- die elektronische Schaltung (612) mindestens zwei elektronische Schaltelemente (202, 206) aufweist, die in einer Halbbrückenschaltung angeordnet sind.

3. Verfahren nach Anspruch 1 oder 2,
**dadurch gekennzeichnet, dass**
- die elektronische Schaltung (712) die zwei elektronischen Schaltelemente (202, 206) und zwei weitere elektronische Schaltelemente (302, 306) aufweist, wobei die zwei elektronischen Schaltelemente (202, 206) und die zwei weiteren elektronischen Schaltelemente (302, 306) in einer Vollbrückenschaltung angeordnet sind.

4. Anordnung (602) mit einer elektronischen Schaltung (612) und einem elektrischen Energiespeicher (210), der mittels eines ersten elektrischen Leiters (606) und eines zweiten elektrischen Leiters (608) mit der elektronischen Schaltung (612) verbunden ist, und mit einem Thyristor (616) zum Entladen des Energiespeichers (210),
**dadurch gekennzeichnet, dass**
der Thyristor (616) derart räumlich benachbart zu dem ersten elektrischen Leiter (606) und/oder dem zweiten elektrischen Leiter (608) angeordnet ist, dass aufgrund eines sich zeitlich ändernden Magnetfelds (1010), welches aufgrund eines durch den ersten elektrischen Leiter (606) und/oder den zweiten elektrischen Leiter (608) fließenden Entladestroms (630) des Energiespeichers entsteht und welches das Halbleitermaterial (1006) des Thyristors (616) durchdringt, in dem Halbleitermaterial (1006) des Thyristors ein Strom (1018) induziert wird, der den Thyristor einschaltet.

5. Anordnung nach Anspruch 4,
**dadurch gekennzeichnet, dass**
- der Thyristor (616) in einem Zwischenraum (635) zwischen dem ersten elektrischen Leiter (606) und dem zweiten elektrischen Leiter (608) angeordnet ist.

6. Anordnung nach Anspruch 4 oder 5,
**dadurch gekennzeichnet, dass**
- die Anode (620) des Thyristors mit dem ersten elektrischen Leiter (606) verbunden ist und die Kathode (622) des Thyristors mit dem zweiten elektrischen Leiter (608) verbunden ist.

7. Anordnung nach einem der Ansprüche 4 bis 6,
**dadurch gekennzeichnet, dass**
- der Thyristor (616) zwischen dem ersten elektrischen Leiter (606) und dem zweiten elektrischen Leiter (608) mechanisch verspannt ist.

8. Anordnung nach einem der Ansprüche 4 bis 7,
**dadurch gekennzeichnet, dass**
- der Thyristor (616) ein Scheibenzellengehäuse (810) aufweist.

9. Anordnung nach einem der Ansprüche 4 bis 8,
**dadurch gekennzeichnet, dass**
- der erste elektrische Leiter (606) und/oder der zweite elektrische Leiter (608) jeweils als eine Stromschiene ausgestaltet ist.

10. Anordnung nach einem der Ansprüche 4 bis 9,
**dadurch gekennzeichnet, dass**
- der erste elektrische Leiter (606) und/oder der zweite elektrische Leiter (608) jeweils eine ebene Außenfläche (1024, 1026) aufweisen, das Halbleitermaterial des Thyristors eine Scheibe (1006) bildet und die Scheibe (1006) parallel zu mindestens einer der ebenen Außenflächen (1024, 1026) angeordnet ist.

11. Anordnung nach einem der Ansprüche 4 bis 10,
**dadurch gekennzeichnet, dass**
- der Thyristor (616) niederinduktiv mit dem Energiespeicher (210) verbunden ist.

12. Anordnung nach einem der Ansprüche 4 bis 11,
**dadurch gekennzeichnet, dass**
- der Thyristor (616) parallel zu dem Energiespeicher (210) geschaltet ist.

13. Anordnung nach einem der Ansprüche 4 bis 12,
**dadurch gekennzeichnet, dass**
- die elektronische Schaltung (612) mindestens zwei elektronische Schaltelemente (202, 206) aufweist, die in einer Halbbrückenschaltung angeordnet sind.

14. Anordnung nach einem der Ansprüche 4 bis 13,
**dadurch gekennzeichnet, dass**
- die elektronische Schaltung die zwei elektronischen Schaltelemente (202, 206) und zwei weitere elektronische Schaltelemente (302, 306) aufweist, wobei die zwei elektronischen Schaltelemente (202, 206) und die zwei weiteren elektronischen Schaltelemente (302, 306) in einer Vollbrückenschaltung angeordnet sind.

15. Modul (1_1, 1 2, ... 6_n) eines modularen Multilevelstromrichters (1), das eine Anordnung (602, 702) nach einem der Ansprüche 4 bis 14 aufweist.

16. Modularer Multilevelstromrichter (1) mit einer Vielzahl von Modulen (1_1, 1_2, ... 6_n) nach Anspruch 15.

## Claims

1. Method for discharging an electrical energy store (210), which is connected to an electronic circuit (612) by means of a first electrical conductor (606) and a second electrical conductor (608), wherein a thyristor (616) is provided for discharging the energy store (210), wherein in the method
- owing to a fault occurring in the electronic circuit (612), a discharge current (630) of the energy store (210) begins to flow from the energy store (210) via the first electrical conductor (606) to the electronic circuit (612) and via the second electrical conductor (608) back to the energy store (210),
- owing to the discharge current (630) a magnetic field (1010) which changes over time is generated around the first electrical conductor (606) and the second electrical conductor (608), said magnetic field passing through the semiconductor material (1006) of the thyristor (616),
- a current (1018) is induced in the semiconductor material (1006) of the thyristor (616) by the magnetic field (1010) which changes over time,
**characterized in that** the thyristor (616) is switched on by this induced current (1018).

2. Method according to Claim 1,
**characterized in that**
- the electronic circuit (612) has at least two electronic switching elements (202, 206), which are arranged in a half-bridge circuit.

3. Method according to Claim 1 or 2,
**characterized in that**
- the electronic circuit (712) has the two electronic switching elements (202, 206) and two further electronic switching elements (302, 306), wherein the two electronic switching elements (202, 206) and the two further electronic switching elements (302, 306) are arranged in a full-bridge circuit.

4. Arrangement (602) comprising an electronic circuit (612) and an electrical energy store (210), which is connected to the electronic circuit (612) by means of a first electrical conductor (606) and a second electrical conductor (608), and comprising a thyristor (616) for discharging the energy store (210),
**characterized in that**
the thyristor (616) is arranged spatially adjacent to the first electrical conductor (606) and/or the second electrical conductor (608) in such a way that, owing to a magnetic field (1010) which changes over time, which arises owing to a discharge current (630) of the energy store flowing through the first electrical conductor (606) and/or the second electrical conductor (608), and which passes through the semiconductor material (1006) of the thyristor (616), a current (1018) is induced in the semiconductor material (1006) of the thyristor, and this current switches on the thyristor.

5. Arrangement according to Claim 4,
**characterized in that**
- the thyristor (616) is arranged in an interspace (635) between the first electrical conductor (606) and the second electrical conductor (608).

6. Arrangement according to Claim 4 or 5,
**characterized in that**
- the anode (620) of the thyristor is connected to the first electrical conductor (606), and the cathode (622) of the thyristor is connected to the second electrical conductor (608) .

7. Arrangement according to one of Claims 4 to 6,
**characterized in that**
- the thyristor (616) is mechanically braced between the first electrical conductor (606) and the second electrical conductor (608).

8. Arrangement according to one of Claims 4 to 7,
**characterized in that**
- the thyristor (616) has a capsule-type thyristor housing (810) .

9. Arrangement according to one of Claims 4 to 8,
**characterized in that**
- the first electrical conductor (606) and/or the second electrical conductor (608) is/are in each case configured as a busbar.

10. Arrangement according to one of Claims 4 to 9,
**characterized in that**
- the first electrical conductor (606) and/or the second electrical conductor (608) each have a planar outer surface (1024, 1026), the semiconductor material of the thyristor forms a disk (1006), and the disk (1006) is arranged parallel to at least one of the planar outer surfaces (1024, 1026).

11. Arrangement according to one of Claims 4 to 10,
**characterized in that**
- the thyristor (616) is connected with a low inductance to the energy store (210).

12. Arrangement according to one of Claims 4 to 11,
**characterized in that**
- the thyristor (616) is connected in parallel with the energy store (210).

13. Arrangement according to one of Claims 4 to 12,
**characterized in that**
- the electronic circuit (612) has at least two electronic switching elements (202, 206), which are arranged in a half-bridge circuit.

14. Arrangement according to one of Claims 4 to 13,
**characterized in that**
- the electronic circuit has the two electronic switching elements (202, 206) and two further electronic switching elements (302, 306), wherein the two electronic switching elements (202, 206) and the two further electronic switching elements (302, 306) are arranged in a full-bridge circuit.

15. Module (1_1, 1_2, ... 6_n) of a modular multilevel power converter (1), which has an arrangement (602, 702) according to one of Claims 4 to 14.

16. Modular multilevel power converter (1) comprising a multiplicity of modules (1_1, 1_2, ... 6_n) according to Claim 15.

## Revendications

1. Procédé de décharge d'un accumulateur (210) d'énergie électrique, qui est connecté à un circuit (612) électronique au moyen d'un premier conducteur (606) électrique et d'un deuxième conducteur (608) électrique, un thyristor (616) étant prévu pour la décharge de l'accumulateur (210) d'énergie, dans lequel, dans le procédé
- en raison d'un défaut, qui s'est produit dans le circuit (612) électronique, un courant (630) de décharge de l'accumulateur (210) d'énergie commence à passer de l'accumulateur (210) d'énergie au circuit (612) électronique par le premier conducteur (606) électrique et retourne à l'accumulateur (210) d'énergie par le deuxième conducteur (608) électrique,
- en raison du courant (630) de décharge, il est produit, autour du premier conducteur (606) électrique et du deuxième conducteur (608) électrique, un champ (1010) magnétique, qui se modifie avec le temps et qui traverse le matériau (1006 ) semi-conducteur du thyristor (616),
- par la modification avec le du temps du champ (1010) magnétique dans le matériau (1006) semi-conducteur du thyristor (616), on induit un courant (1018),
**caractérisé en ce que** l'on rend passant le thyristor (616) par ce courant (1018) induit.

2. Procédé suivant la revendication 1,
**caractérisé en ce que**
- le circuit (612) électronique a au moins deux éléments (202, 206) électroniques de coupure, qui sont montés en un circuit en demi-pont.

3. Procédé suivant la revendication 1 ou 2,
**caractérisé en ce que**
- le circuit (712) électronique a les deux éléments (202, 206) électroniques de coupure et deux autres éléments (302, 306) électroniques de coupure, les deux éléments (202, 206) électroniques de coupure et les deux autres éléments (302, 306) électroniques de coupure étant montés en un circuit en pont complet.

4. Montage (602), comprenant un circuit (612) électronique et un accumulateur (210) d'énergie électrique, qui est connecté au circuit (612) électronique au moyen d'un premier conducteur (606) électrique et d'un deuxième conducteur (608) électrique et comprenant un thyristor (616) pour décharger l'accumulateur (210) d'énergie,
**caractérisé en ce que**
le thyristor (616) est disposé dans l'espace au voisinage du premier conducteur (606) électrique et/ou du deuxième conducteur (608) électrique, **en ce que**, en raison d'une modification (1010) avec le temps du champ magnétique, qui se crée en raison d'un courant (630) de décharge de l'accumulateur d'énergie passant dans le premier conducteur (606) électrique et/ou dans le deuxième conducteur (608) électrique et qui traverse le matériau (1006) semi-conducteur du thyristor (616), il est induit, dans le matériau (1006) semi-conducteur du thyristor, un courant (1018), qui rend passant le thyristor.

5. Montage (602) suivant la revendication 4,
**caractérisé en ce que**
- le thyristor (616) est disposé dans un espace (635) intermédiaire entre le premier conducteur (606) électrique et le deuxième conducteur (608) électrique.

6. Montage (602) suivant la revendication 4 ou 5,
**caractérisé en ce que**
- l'anode (620) du thyristor est connectée au premier conducteur (606) électrique et la cathode (622) du thyristor est connectée au deuxième conducteur (608) électrique.

7. Montage (602) suivant l'une des revendications 4 à 6,
**caractérisé en ce que**
- le thyristor (616) est serré mécaniquement entre le premier conducteur (606) électrique et le deuxième conducteur (608) électrique.

8. Montage (602) suivant l'une des revendications 4 à 7,
**caractérisé en ce que**
- le thyristor (616) a un boîtier (81) de cellule en disque.

9. Montage (602) suivant l'une des revendications 4 à 8,
**caractérisé en ce que**
- le premier conducteur (606) électrique et/ou le deuxième conducteur (608) électrique sont conformés chacun sous la forme d'une barre de courant.

10. Montage (602) suivant l'une des revendications 4 à 9,
**caractérisé en ce que**
- le premier conducteur (606) électrique et/ou le deuxième conducteur (608) électrique ont chacun une surface (1024, 1026) extérieure plane, le matériau semi-conducteur du thyristor forme un disque (1006) et le disque (1006) est disposé parallèlement à au moins l'une des surfaces (1024, 1026) extérieures planes.

11. Montage (602) suivant l'une des revendications 4 à 10,
**caractérisé en ce que**
- le thyristor (616) est connecté à faible induction à l'accumulateur (210) d'énergie.

12. Montage (602) suivant l'une des revendications 4 à 11,
**caractérisé en ce que**
- le thyristor (616) est monté en parallèle à l'accumulateur (210) d'énergie.

13. Montage (602) suivant l'une des revendications 4 à 12,
**caractérisé en ce que**
- le circuit (612) électronique a au moins deux éléments (202, 206) électroniques de coupure, qui sont montés en un circuit en demi-pont.

14. Montage (602) suivant l'une des revendications 4 à 13,
**caractérisé en ce que**
- le circuit (712) électronique a les deux éléments (202, 206) électroniques de coupure et deux autres éléments (302, 306) électroniques de coupure, les deux éléments (202, 206) électroniques de coupure et les deux autres éléments (302, 306) électroniques de coupure étant montés en un circuit en pont complet.

15. Module (1_1, 1_2, ... 6_n) d'un onduleur (1) modulaire à plusieurs niveaux, qui a un montage (602, 702) suivant l'une des revendications 4 à 14.

16. Onduleur (1) modulaire à plusieurs niveaux ayant une pluralité de modules (1_1, 1_2, ... 6_n) suivant la revendication 15.
